Europäisches Patentamt

European Patent Office

Office européen des brevets

(19)

(11)  **EP 1 610 138 A1**

(12)  **EUROPEAN PATENT APPLICATION**
published in accordance with Art. 158(3) EPC

(43) Date of publication:
    **28.12.2005 Bulletin 2005/52**

(51) Int Cl.⁷: **G01R 31/36**

(21) Application number: **04722638.6**

(86) International application number:
    **PCT/JP2004/003914**

(22) Date of filing: **23.03.2004**

(87) International publication number:
    **WO 2004/088341 (14.10.2004 Gazette 2004/42)**

(84) Designated Contracting States:
    **AT BE BG CH CY CZ DE DK EE ES FI FR GB GR
    HU IE IT LI LU MC NL PL PT RO SE SI SK TR**
    Designated Extension States:
    **AL LT LV MK**

(30) Priority: **31.03.2003 JP 2003097472**

(71) Applicant: **YAZAKI CORPORATION**
    **Minato-ku Tokyo 108-8333 (JP)**

(72) Inventors:
    • **ARAI, Youichi, c/o Yazaki Corporation**
      **Susono-shi, Shizuoka 410-1194 (JP)**
    • **ENOMOTO, Michito, c/o Yazaki Corporation**
      **Susono-shi, Shizuoka 410-1194 (JP)**
    • **AMANO, Kenichi, c/o Yuasa Corporation**
      **Takatsuki-shi, Osaka 569-1115 (JP)**

(74) Representative: **Viering, Jentschura & Partner**
    **Steinsdorfstrasse 6**
    **80538 München (DE)**

(54)  **METHOD AND DEVICE FOR ESTIMATING BATTERY'S DISCHARGEABLE CAPACITY**

(57)  A unit for estimating voltage drop 23a-1 estimates voltage drop of a battery terminal when maximum current is continuously supplied at high rate discharge. A unit for estimating residual discharge capacity 23a-2 estimates residual discharge capacity of the battery for allowing the maximum current to be continuously supplied to a load by subtracting the undischargeable electric charge calculated from the voltage drop estimated by the unit for estimating voltage drop 23a-1 from the dischargeable charge in any state of charge.

FIG. 1

## Description

[TECHNICAL FIELD]

This invention relates to a method for estimating residual discharge capacity of a battery, and an apparatus for the same.

[BACKGROUND ART]

Remaining discharge capacity of a battery continuously changes. For appropriately operating a load with electric power supplied by the battery, the residual discharge capacity estimation is needed. For example, a suitable estimation of residual discharge capacity of a battery in a vehicle, although varied a little corresponding to a vehicle type, is required for the following reasons.

For example, in a conventional engine vehicle, a battery supplies electric power to a starter motor for starting an engine. If the battery cannot supply the power, the engine will not start. After the engine starts, a generator driven by the engine generates the electric power to charge the battery and operate the load. Therefore, the battery becomes a secondary source. If the generator is troubled, of course, the battery becomes an only electric source to operate the load, and becomes important.

Further, in an electric vehicle having an electric motor driven by the electric power from a battery, battery is an only source. So, if the battery cannot supply the power, the vehicle will stop.

Further, in a hybrid vehicle having a motor driven by electric power supplied from both an engine and a battery, the engine often stops and the battery alternatively supplies the electric power while the vehicle is moving. However, if the battery cannot supply the power for starting the starter motor, the engine will not start.

According to the above, the residual discharge capacity of a battery should be known for charging the battery while at least the battery can start the starter motor of the engine vehicle, or drive the electric motor of the electric vehicle. Further, the residual discharge capacity of the battery in the electric vehicle is equivalent to a remaining fuel level, and required to be known quantitatively.

Incidentally, amount of charge available in a battery is generally expressed by SOC (state of charge). On the contrary, amount of charge to operate a load is generally expressed by ADC. ADC is defined as electric charge expressed by multi-Ampere-Hour (Ah), corresponding to a difference between fully charged SOC and finally discharged SOC. Sometimes, the ADC is expressed by volume percent in which the fully charged SOC is 100 %, and the finally discharged SOC is 0 %.

Incidentally, it is known that the SOC of the battery is constantly related to an open circuit voltage as an open terminal voltage of a battery in an equilibrium condition in which various polarizations due to charge-discharge cycles are canceled. Generally, the SOC of the battery is calculated from the relationship and the measured or estimated open circuit battery (for example, JP-A, 2002-236157). Since the SOC is expressed by ampere-hour, the continuously changed SOC is known by measuring electric current through battery terminals against time through the charge-discharge cycles.

The SOC described above is electrical charge extracted from the battery, however, since an internal electrical resistance exists in the battery, the terminal voltage of the battery is reduced by an internal voltage drop corresponding to the discharging current and the internal resistance. Therefore, an electrical charge of the SOC in a state that the terminal voltage is less than an operable voltage for the load (end of discharge voltage) is not regarded as the electrical charge capable of operating the load.

According to the conventional ADC described above, the residual discharge capacity is simply defined as the difference between a currently available SOC and the SOC corresponding to the end of discharge voltage. Therefore, although the dischargeable capacity remains in the battery according to the ADC, when the load is actually tried to be driven, the load may not be driven. Therefore, there is a demand for a method for estimating residual discharge capacity of a battery and an apparatus for the same for reliably driving the load.

[DISCLOSURE OF INVENTION]

An object of the present invention is to provide a method for estimating residual discharge capacity of a battery and an apparatus for the same for reliably driving a load.

For attaining the object, each aspect of the present invention allows to estimate residual discharge capacity for reliably driving a load by estimating a maximum battery voltage drop due to an internal resistance thereof corresponding to a maximum current at high rate discharge to a load.

For attaining the object, according to a first aspect of the present invention, there is provided a method for estimating residual discharge capacity of a battery for allowing a maximum current to be supplied continuously to a load, said method including the steps of:

estimating a terminal voltage drop of the battery when a maximum current at high rate discharge is continuously supplied to the load ; and
estimating the residual discharge capacity by subtracting undischargeable charge calculated based on the estimated terminal voltage drop of the battery from dischargeable charge in the battery in any state of charge. According to this method, it is possible to manage the residual discharge capacity for surely driving the load with the maximum current as long as a reminder of dischargeable charge exists.

For attaining the object, according to a second aspect of the present invention, there is provided a method for estimating residual discharge capacity of a battery for allowing a maximum current to be supplied continuously to a load, said method including the steps of:

estimating a maximum terminal voltage drop of the battery when a maximum current at high rate discharge is continuously supplied to the load; calculating a rate of the estimated maximum terminal voltage drop of the battery to a maximum allowable voltage drop of the battery corresponding to the maximum current, estimating the residual discharge capacity by subtracting undischargeable charge calculated based on the rate from dischargeable charge in the battery in any state of charge. According to this method, it is possible to manage the residual discharge capacity for allowing the maximum current to be supplied to the load as long as the residual dischargeable charge exists.

The maximum voltage drop is a differential voltage between an already known full-charge open circuit voltage of the battery and an end of on-load discharge voltage defined by a limit voltage to supply the maximum current to the load. Therefore, this maximum voltage drop can be defined previously corresponding to the maximum current. Since the maximum voltage drop at high rate discharge is estimated, the rate of the estimated maximum voltage drop to the maximum allowable voltage drop of the battery corresponding to the maximum current is easily determined.

The estimated voltage drop includes a voltage drop due to resistance component due to a resistance component of the battery estimated at high rate discharge, an increased voltage drop due to resistance component due to an maximum increased resistance component varied corresponding to the charged condition of the battery estimated at high rate discharge, a saturated voltage drop due to polarization as a maximum voltage drop due to polarization generated by the maximum current. Therefore, the estimated voltage drop means the maximum voltage drop including the polarization voltage increasing toward a saturation point. Further, the voltage drop due to resistance component includes a voltage drop due to a variation of the resistance component increased or decreased by the charged condition, ambient temperature, or degradation. Therefore, it is possible to manage the residual discharge capacity properly including the entire variable factor.

This saturated voltage drop due to polarization is estimated as a voltage drop due to polarization corresponding to a maximum point of an electric current given by an approximated curve of current-polarization characteristics of the voltage drop due to polarization obtained by removing the voltage drop due to resistance component from an approximated curve of a current-voltage characteristics derived based on data pairs obtained by periodically measuring the discharge current to the load at high rate discharge, and terminal voltages of the battery corresponding to the discharge current. Further, using the resistance component estimated at high rate discharge, the saturated voltage drop due to polarization is estimated.

For attaining the object, according to a third aspect of the present invention, there is provided a method for estimating residual discharge capacity of a battery for allowing a maximum current to be supplied continuously to a load, said method including the steps of:

estimating a maximum terminal voltage drop of the battery when a maximum current at high rate discharge is continuously supplied to the load; and estimating the residual discharge capacity by subtracting undischargeable charge calculated based on the estimated maximum terminal voltage drop of the battery from dischargeable charge in the battery in any state of charge. According to this method, since the residual discharge capacity is calculated by subtracting all the maximum voltage drop generated by continuously flowing the maximum current, it is possible to properly manage the residual discharge capacity for allowing the maximum current to drive the load as long as the dischargeable charge exists.

In the methods described above, preferably, the residual discharge capacity is revised by multiplying the estimated residual discharge capacity of a battery by a rate that is previously calculated by dividing residual discharge capacity of a deteriorated battery by that of a not deteriorated battery.

According to this method, it is possible to properly manage the residual discharge capacity of a battery for reliably driving a load with any electric current even if the battery is deteriorated.

For attaining the object, according to a fourth aspect of the present invention, there is provided an apparatus for estimating residual discharge capacity of a battery for allowing a maximum current to be supplied continuously to a load, said apparatus including:

a device for estimating maximum terminal voltage drop of the battery at a time when a maximum current at high rate discharge is continuously supplied to the load; and a device for estimating the residual discharge capacity by subtracting undischargeable charge calculated based on the estimated terminal voltage drop of the battery from dischargeable charge in the battery in any state of charge. According to this apparatus, it is possible to manage the residual discharge capacity of a battery for allowing a maximum current to be supplied continuously to a load.

Preferably, this apparatus for estimating residual discharge capacity of a battery further includes:

a device for calculating a rate of said estimated voltage drop to a differential voltage between an end of on-load discharge voltage defined by a limit voltage to supply the maximum current to the load and an already known full-charge open circuit voltage of the battery; and
a device for estimating residual discharge capacity by subtracting charge corresponding to said calculated rate using the end of on-load discharge voltage at high rate discharge from dischargeable charge in the battery in any state of charge. According to the above, it is possible to easily estimate the discharge capacity of the battery in any state-of-charge by using the rate of the maximum voltage drop estimated at high rate discharge to the differential voltage previously determined as the already-known value after the maximum current is determined.

The device for estimating a terminal voltage drop includes: a device for estimating a voltage drop due to a resistance component of the battery estimated at high rate discharge; a device for calculating a voltage drop due to an maximum increased resistance component varied corresponding to the state of charge of the battery; and a device for estimating a saturated voltage drop due to polarization as a maximum voltage drop due to polarization generated by the maximum current, wherein said device for estimating a terminal voltage drop estimates the maximum voltage drop based on voltages calculated or estimated by said respective devices. According to the above, the voltage drop includes the voltage drop due to polarization increasing toward the saturation point when the maximum current continuously flows. Further, the estimated resistance component includes variations increased or decreased by the state of charge, temperature, and deterioration. Therefore, the residual discharge capacity of a battery including all variations is properly managed for reliably driving a load that requires maximum current.

The device for estimating a saturated voltage drop due to polarization estimates the saturated voltage drop due to polarization as a maximum voltage drop due to polarization corresponding to electric current given by an approximated curve of current-polarization characteristics of the voltage drop due to polarization obtained by removing the voltage drop due to resistance component from an approximated curve of a current-voltage characteristics derived based on data pairs obtained by periodically measuring the discharge current to the load at high rate discharge, and terminal voltages of the battery corresponding to the discharge current. Therefore, using the estimated resistance component at high rate discharge, the saturated voltage due to polarization is also estimated.

**[BRIEF DESCRIPTION OF THE DRAWINGS]**

Fig. 1 is a block diagram showing a basic structure of an apparatus for estimating residual discharge capacity according to the present invention for accomplishing a method for estimating residual discharge capacity according to the present invention;
Fig. 2 is a schematic diagram showing a concrete structure of the apparatus for estimating residual discharge capacity for accomplishing the method for estimating residual discharge capacity according to the present invention;
Fig. 3 is a graph showing changes of discharge current and terminal voltage of a battery at high rate discharge;
Fig. 4 is a graph for explaining a principle of the method for estimating residual discharge capacity according to the present invention;
Fig. 5 is a graph for explaining how to estimate a saturated voltage drop due to polarization in Fig. 4; and
Fig. 6 is a flowchart showing a main process processed by a micro computer shown in Fig. 2, following a predetermined program for estimating the residual discharge capacity of a battery.

[BEST MODE FOR CARRYING OUT THE INVENTION]

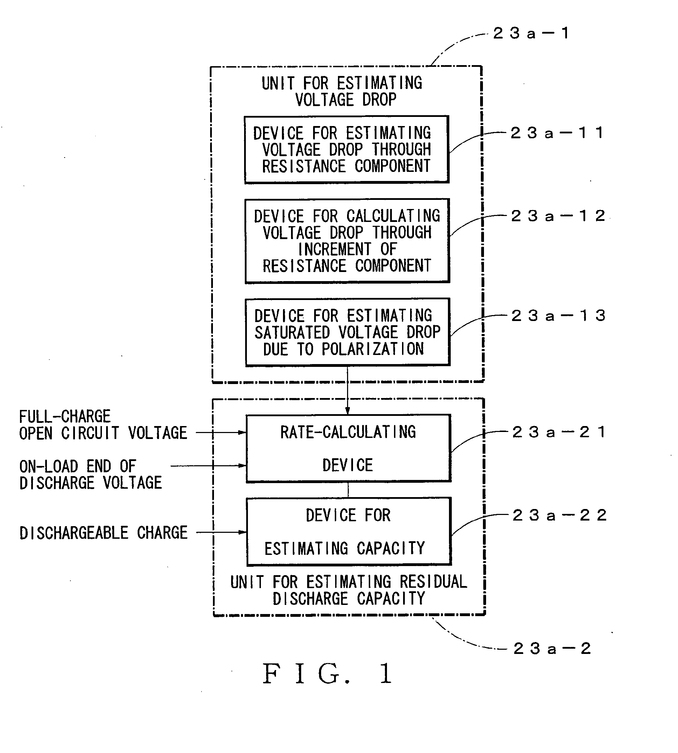

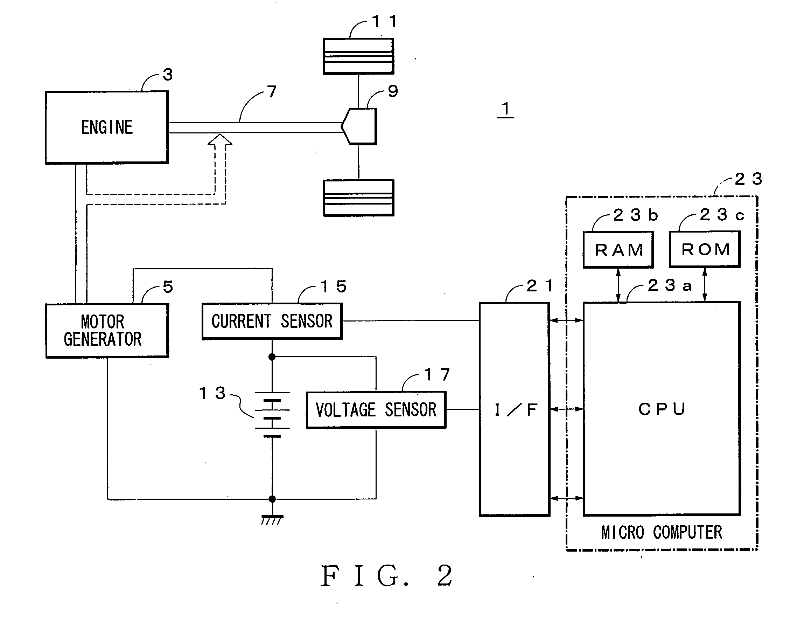

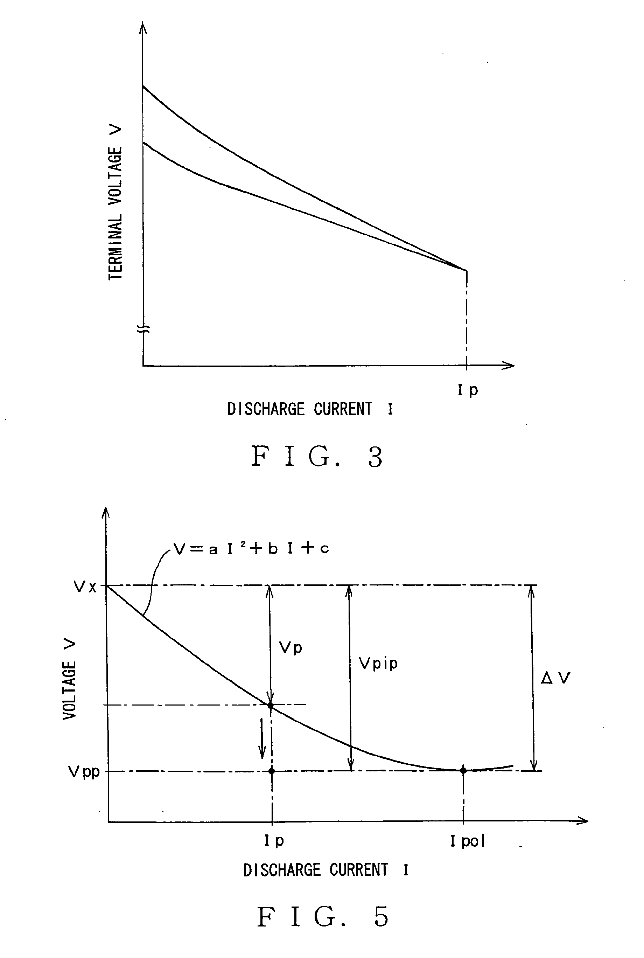

Hereunder, a method and an apparatus 1 for estimating residual discharge capacity of a battery according to the present invention will be explained. A basic structure of the apparatus of this invention is shown in a block diagram of Fig. 1, and a concrete structure of the same is shown in Fig. 2. Preliminarily, a basic concept of the present invention will be explained with reference to Figs. 3 to 5.

Generally, terminal voltage of a battery indicates a state of charge of a battery. The terminal voltages of balanced or unbalanced batteries are different. It is also known that the terminal voltage reflects a voltage drop due to an internal resistance of the battery and discharge current from the battery. Accordingly, this invention focuses this situation, and estimates residual discharge capacity of the battery as a dischargeable charge for reliably driving a specific load by identifying an origin of voltage drop caused inside the battery during high rate discharge in a specific condition.

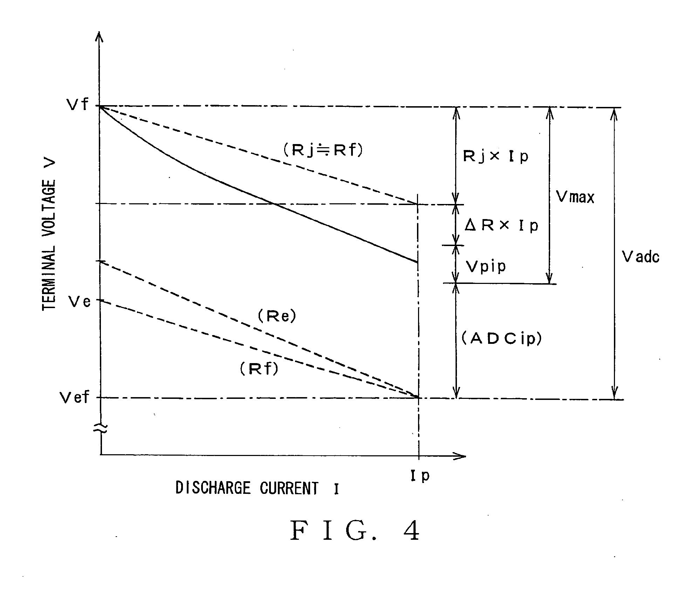

For example, in a vehicle, discharge is occurred through a starter motor when an engine starts. At this time, so-called rush current flows. The rush current increases in a short time to a maximum current being enormously larger than steady-state current and decreases to the steady-current in a short time. Generally, such a discharge is called as high rate discharge. A characteristic curve of discharge current-terminal voltage shown in Fig. 3 is obtained by firstly measuring the discharge current and the battery terminal voltage in high rate discharge using a high speed sampling, secondly calculated approximately by such as a least squares method. In the characteristic curve of the approximate calculation, the Factors in decrease of the terminal voltage against increase of the discharge current includes the voltage drop due to the internal resistance of the battery. With reference to Fig. 4, by focusing a voltage corresponding to the maximum current (peak current) of the discharge current, a breakdown of the voltage drop will be examined.

Firstly, the voltage drop at the maximum current includes a voltage drop ($Rj * Ip$) due to a maximum current Ip flowing through an internal resistance component Rj. The internal resistance component Rj is estimated by analyzing two approximated curves derived from the data pair measured by the sampling in high rate discharge described above, however, a detailed explanation about this estimation is omitted.

This internal resistance component Rj includes variations due to the state of charge, namely, increment accompanying a reduction of the current SOC, temperature, and deterioration of the battery.

The increment of the resistance component accompanying the state of charge of the battery is varied between a minimum value in the full-charged state, and a maximum value in an end of discharge voltage. The maximum increment of the voltage drop due to resistance component is due to a differential resistance ($\Delta R = Re - Rf$) between an already-known resistance component Rf in full charged state determined by a design spec of the battery, and a resistance component Re in end of charge state. The maximum increment of the voltage drop due to resistance component is calculated by an expression ($Re - Rf$) * Ip.

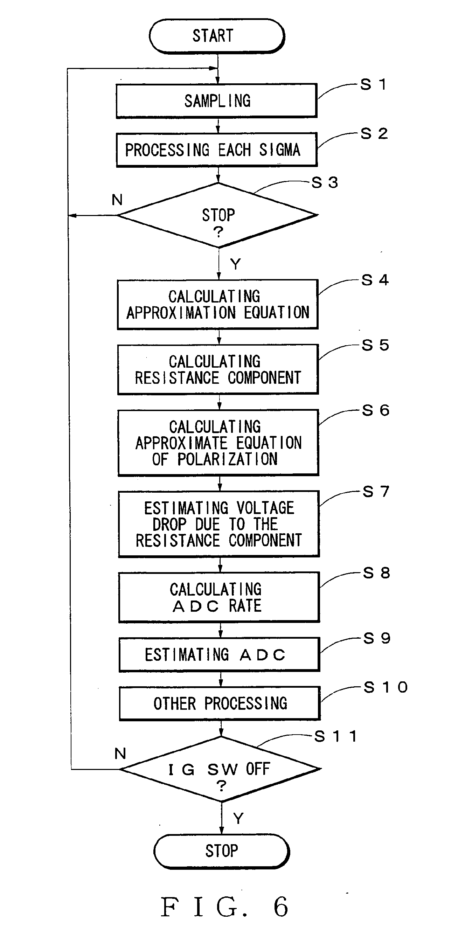

Another factor of the voltage drop except the voltage drop of the resistance component ($Rj * Ip$) is due to polarization generated in the battery. Therefore, by subtracting the voltage drop of the resistance component from the approximated curve of the discharge current-terminal voltage, a quadratic approximated curve of the voltage drop due to polarization as shown in Fig. 5 is obtained.

Incidentally, according to a document "a cell as a function of operative current" in "Handbook of batteries" by David Linden et al. page 10, Fig 2. 1, when a certain amount of electric current flows, a saturated voltage drop due to polarization corresponding to the amount of the current exists.

Therefore, a differential voltage $\Delta V$ between a maximum voltage drop Vpp in the quadratic approximated curve of the voltage drop due to polarization and a terminal voltage Vx before starting is estimated as the saturated polarized voltage (Vpip) as a maximum saturated voltage drop due to polarization at a maximum electric current Ip in high rate discharge. How to determine the saturated polarized voltage (Vpip) and how to obtain the quadratic approximated curve of the voltage drop due to polarization will be explained later.

Resultingly, a total voltage drop (Vmax) as a maximum voltage drop generated in the battery while the maximum electric current flows continuously is estimated by adding the voltage drop ($Rj * Ip$) due to the internal resistance component Rj, the increment ($\Delta R * Ip$) of the maximum voltage drop due to resistance component, and the saturated polarized voltage (Vpip) shown in Fig. 5. Such an occurrence of voltage drop in a battery reduces the residual discharge capacity of the battery.

On the other hand, an end of on-load discharge voltage (Vef) corresponding to the maximum voltage drop allowable in the maximum current discharge is estimated by adding an unrealistic but assumed internal minimum voltage drop caused in the maximum current discharge, namely, a voltage drop calculated by multiplying the resistance component in full-charge by the maximum current ($Rf * Ip$) to the already-known end of discharge voltage (Ve).

Then, by subtracting a ratio (Vmax / Vadc) of the total voltage drop ($Vmax = Rj * Ip + \Delta R * Ip + Vpip$) to the differential voltage ($Vadc = Vf - Vef$) between the end of on-load discharge voltage (Vef) and a open-circuit voltage in full-charge (Vf) from an originally dischargeable capacity, a dischargeable capacity ratio (ADC ratio) is calculated (= 100% - (Vmax / Vadc) * 100 %). Then, by multiplying a difference $\Delta SOC$ between an estimated dischargeable capacity based on a measured or estimated OCV (open circuit voltage), namely, SOCj corresponding to the OCV, and SOCef corresponding to the end of on-load discharge voltage by the ADC ratio, capacitance to allow a continuous maximum current at high rate discharge ADCip is estimated.

The quadratic approximated curve of the voltage drop due to polarization is obtained by subtracting the voltage drop due to the resistance component from the quadratic approximated curve of discharge current-terminal voltage in the increase of the electric current. Here, the quadratic approximated curve of the voltage drop due to polarization is expressed in an expression:

$$V = a*I^2 + b*I + c$$

This battery terminal voltage V means the voltage drop due to the internal resistance except the voltage drop due to the resistance component Rj.

This expression is differentiated for obtaining a voltage drop $\Delta V / \Delta I$ per unit current.

$$\Delta V / \Delta I = 2a*I + b$$

Saturation point is a point where $\Delta V / \Delta I = 0$, and a maximum value in the approximated curve. Therefore, an expression below is obtained.

$$0 = 2*a*I + b$$

A re-arranged expression is:

$$I = - b./ 2a$$

Therefore, by substituting this electric current I in an approximate expression corresponding to the quadratic approximated curve of the voltage drop due to polarization, the saturated polarized voltage (Vpip) as the maximum voltage drop due to polarization at the maximum current Ip is obtained.

In addition, if the discharge is started from an unbalanced state having some polarization, since a differential voltage estimated at a start point between the open circuit voltage OCV in the balanced state and a terminal voltage is not included in the voltage drop due to polarization at the maximum current Ip determined by the approximate expression, it is necessary to add the differential voltage into the saturated polarized voltage (Vpip).

The apparatus for estimating residual discharge capacity of a battery according to the present invention as shown by a basic structure in Fig. 1 includes: a unit for estimating voltage drop 23a-1 that estimates voltage drop of a battery terminal when the maximum current is continuously supplied at high rate discharge; and a unit for estimating residual discharge capacity 23a-2 that estimates residual discharge capacity of the battery for allowing the maximum current to be continuously supplied to a load by subtracting the undischargeable electric charge calculated from the voltage drop estimated by the unit for estimating voltage drop 23a-1 from the dischargeable charge in any state of charge. According to the above, it is possible to manage the residual discharge capacity as long as a reminder of dischargeable charge exists.

The unit for estimating residual discharge capacity 23a-2 includes: a rate-calculating device 23a-21 that calculates the rate of the estimated voltage drop to the differential voltage between the well-known full-charge open terminal voltage and the end of on-load discharge voltage; and a device for estimating capacity 23a-22 that estimates the dischargeable charge by subtracting the charge corresponding to the rate from the charge at any state of charge. According to the above, it is possible to determine the residual discharge capacity at any time easily by using a rate of the maximum voltage drop estimated at high rate discharge to the differential voltage previously determined as the already-known value after the maximum current is determined.

The unit for estimating voltage drop 23a-1 includes: a device for estimating voltage drop through resistance component 23a-11 of a battery at high rate discharge; a device for calculating voltage drop through increment of resistance component 23a-12 that is varied corresponding to the state of charge of the battery; a device for estimating saturated voltage drop due to polarization 23a-13 as the maximum voltage drop generated by the maximum current. According to the above, the maximum voltage drop is estimated using estimated or calculated voltages by respective devices, and includes a maximum polarized voltage that increases toward the saturation point by the maximum current, and the estimated voltage drop through the resistance component includes variations due to the resistance component that is varied by the state of charge, temperature, and deterioration. Therefore, it is possible to properly manage the residual discharge capacity for reliably driving a load with all variable factors.

The device for estimating saturated voltage drop due to polarization 23a-13 estimates the voltage drop due to polarization by calculating the maximum voltage drop corresponding to the current using the approximated curve of the current- polarization characteristic eliminating the voltage drop through the resistance component, obtained by the approximated curve of the current-voltage characteristics based on the data pair from the periodic measurement of the discharge current and the on- load terminal voltage of the battery at high rate discharge, and also estimates the polarized saturated voltage drop using the resistance component estimated at high rate discharge.

Fig. 2 shows a schematic diagram showing a schematic structure of the apparatus for estimating residual discharge capacity shown in Fig. 1, used for a battery mounted on a vehicle, and accomplishing a method for estimating residual discharge capacity according to the present invention. The apparatus as one embodiment of the present invention indicated by reference numeral 1 in Fig. 2 is mounted on a hybrid vehicle having an engine 3 and a motor generator 5.

This hybrid vehicle is configured to drive by transmitting power output of only an engine 3 to wheels 11 through a driving shaft 7 and a differential case 9 in normal driving, and to be assisted by using a motor generator 5 as a motor with electric power from a battery 13, and transmitting power output of the motor generator 5 in addition to the engine 3 through the driving shaft 7 to the wheels 11.

Further, this hybrid vehicle is configured to use the motor generator 5 as a generator while reducing speed or braking for charging the battery 13 by transforming kinetic energy into electric energy.

Incidentally, in a vehicle, when an ignition switch or accessory switch (ACC) is on, discharge current is supplied from the battery according to power supply to the loads being on. The motor generator 5 is used also as a starter motor for compulsory rotate a flywheel of the engine 3 when a not-shown starter switch is on for starting the engine 3. In this case, a large rush current is supplied through the motor generator 5 in a short time. After the engine 3 is started, according to a turn-off operation of a not-shown ignition key, the starter switch turns off and the ignition switch turns on. According to the turn-on of the ignition switch, the discharge current through the battery 13 shifts to steady state current corresponding to the loads.

As the constitution described above, the apparatus 1 for estimating residual discharge capacity of a battery according to the present invention includes: a motor generator used for an assisting motor and a starter motor, a current sensor 15 for detecting discharge current "I" for electric components from the battery 13 and charging current to the battery 13 from the motor generator 5 as the generator; and a voltage sensor 17 having an about 1 meg ohm resistor parallel to the battery 13 for detecting a terminal voltage of the battery 13.

The apparatus 1 for estimating residual discharge capacity of a battery according to the present invention further includes: an interface circuit 21 which outputs of the current sensor 15 and the voltage sensor 17 are inputted into and converted analog to digital; and a micro computer 23 into which the converted outputs are inputted through the interface circuit 21.

The microcomputer 23 includes a CPU 23a, a RAM 23b, and a ROM 23c. The CPU 23a is connected to the RAM 23b, the ROM 23c, and the interface circuit 21. The CPU 23a is also connected to the not-shown starter switch, the ignition switch, the accessory switch, and other switches of the electric components (loads) except the motor generator 5.

The ROM 23b includes a data area for storing various data and a working area for various processing. The ROM 23c stores a control program for the various operations of the CPU 23.

Incidentally, the values of electric current and voltage as the respective outputs of the current sensor 15 and the voltage sensor 17 are rapidly sampled in a short period, then outputted to the CPU 23a of the microcomputer 23 through the interface circuit 21, and used for the various processing.

Next, a process of the CPU 23 according to the control program stored in the ROM 23c will be explained with reference to a flowchart shown in Fig. 6.

After the ignition switch is on, the battery supplies the power to start the microcomputer 23, and the program is started sequentially, the CPU 23a starts sampling the discharge current and the terminal voltage in a relatively long period (step S1). The CPU 23a reads measured data pair of the A/D converted discharge current I and the terminal voltage V through the interface circuit 21, and monitors whether the discharge current over turns over a predetermined value or not. If the discharge current is over the predetermined value, the CPU 23a judges that the rush current begins to be supplied. The CPU 23a switches the sampling period to a short period such as 100 μsec and prepares to derive the approximate expression (step S2). This process is carried out in a middle of a process for deriving an approximate expression for detecting the maximum discharge current (peak current).

Least-squares method is used for deriving the approximate expression. Each sigma is calculated according to the sampled data pair of discharge current and terminal voltage for deriving the approximate expression of increasing current. When the sampling data decreases continuously "n" (predetermined number) times, the CPU 32a judges that the discharge current turns to decrease from a peak value, and calculates each sigma for deriving the approximate expression of decreasing current based on the sampled data of discharge current and terminal voltage. Then, the CPU 23a monitors whether the discharge current turns under a predetermined value or not. When the discharge current turns under the predetermined value, the CPU 23a judges that the rush current stops, and ends the process for deriving the approximate expression (step S3). Then, the approximate expressions of the increasing and decreasing current are calculated from the stigma respectively (step S4).

Incidentally, though being not shown in the flowchart of Fig. 6, a judgement whether the derived approximate expressions is valid or not is naturally required. This judgement can be made by comparing correlation coefficients when the current increases and decreases using results of the sigma calculation and a peak current value with predetermined values. In particular, setting two specific values can remove error factors.

The CPU 23a calculates for finding the resistance component of the battery using a quadratic approximation derived from above (step S5). In this calculation, if the voltage drop due to concentration polarization is included in the quadratic approximation, the CPU 23a recalculates for finding amended quadratic approximations in which the voltage drop due to concentration polarization is canceled. In this case, the CPU 23a firstly calculates derivative values at peak values of the two amended quadratic approximations of current - voltage characteristics of the increasing and decreasing discharge current. Then, the CPU 23a calculates to find an intermediate value between the two derivative values as the resistance component of the battery. This calculated resistance component of the battery is stored in the data area of the RAM 23b for being used for various purposes.

There are two methods for finding the intermediate value of the derivative values according to flow patterns of the rush current.

When increasing and decreasing times of the rush current are nearly equal, the CPU calculates an average of the two derivative values as the resistance component Rj.

On the other hand, when the increasing and decreasing times are much different from each other, the CPU 23a calculates a sum of a product of a derivative value of a peak value in the amended quadratic approximation of the current-voltage characteristic of the increasing discharge current and a rate of a flowing time of the increasing discharge current to a total time of the discharge current, and a product of a derivative value of a peak value in the amended quadratic approximation of the current-voltage characteristic of the decreasing discharge current and a rate of a flowing time of the decreasing discharge current to a total time of the discharge current, as the resistance component. According to either method, the resistance component of the battery Rj is calculated as the intermediate value of the two derivative values.

In addition, in the case above, the first and the second approximate expressions are quadratic approximations. However, if the first approximation is a linear approximate expression, the amended approximate expression is not needed naturally In this case, a gradient of the linear expression is used instead of the

Incidentally, references for a detail of the calculating method for the battery resistance component described above are, for example, patent documents of US-2002-01860-A1 and DE10223506A1.

Next, the CPU 23a calculates a approximate expression for the voltage drop due to other factors except the resistance component when the current increases, namely, a approximate expression of the polarization when the current increases by using the resistance component Rj calculated in the step S5, and canceling the voltage drop due to the resistance component derived from the approximate expression when the current increases calculated at the step S4 (step S6). The resistance component calculated at the step S5 and the approximate expression of the polarization calculated at step S6 are used for calculating voltage drops due to the resistance component and polarization in a process for estimating a total voltage drop at next step S7.

In the process for estimating a total voltage drop at the step S7, the CPU 23a estimates the total voltage drop as the maximum voltage drop including the polarization that increases toward the saturation point when the maximum discharge current is continuously supplied. The maximum voltage drop includes: the voltage drop (Rf * Ip) due to the resistance component Rj of the battery calculated at the step 5; the saturated voltage drop due to the polarization Vpip that is the maximum voltage drop due to the polarization generated by the maximum current.

The voltage drop due to the resistance component is calculated by multiplying the calculated resistance component Rj by the maximum current Ip. This includes a variation of the resistance component due to state of charge, temperature, and deterioration. The voltage drop due to the increment of the resistance component is generated by the maximum increment of the resistance component corresponding to the state of charge of the battery. The maximum increment of the voltage drop due to resistance component is due to a differential resistance (ΔR = Re - Rf) between an already-known resistance component Rf in full charged state determined by a design spec of the battery, and a resistance component Re in end of charge state. The maximum increment of the voltage drop due to resistance component is calculated by an expression (Re - Rf) * Ip. Further, the voltage drop due to polarization Vpip is estimated as the maximum voltage drop due to polarization at the current calculated by using the approximate expression for the voltage drop due to the polarization at the maximum current calculated at the step S6.

After the maximum voltage drop is calculated by the estimation of the total voltage drop at the step S7, the CPU 23a calculates ADC rate at step S8. This ADC rate is defined as a rate of residual discharge capacity to a total capacity equivalent to a rate of the maximum internal voltage drop of the battery to the maximum terminal voltage drop of the battery when the maximum discharge current continuously is continuously supplied at high rate discharge.

The ADC rate indicates a dischargeable capacity ratio and is calculated by an expression 100% - (Vmax / Vadc) * 100 %, wherein Vef is the end of on-load discharge voltage, Vf is a open-circuit voltage in full-charge, Vmax is the total voltage drop, and Vadc is a differential voltage Vf - Vef.

After the ADC rate is calculated at the step S8, the CPU 23a calculates the ADC with the calculated ADC rate (step S9). Specifically, the CPU 23a treats calculation result of multiplying a difference (ΔSOC) between the assumed residual discharge capacity estimated from the measured or estimated OCV, namely, SOCj corresponding to the OCV, and SOCef corresponding to the end of on-load discharge voltage, as the residual discharge capacity (ADCip) when the maximum discharge current is continuously supplied at high rate discharge.

The ADC estimated at the step S9, namely, the residual discharge capacity when the maximum discharge current is continuously supplied at high rate discharge is used in the following process (step S10). For example, when a vehicle is stopped and the CPU 23a judges whether to stop the engine idling or not, the ADC estimated stop at the step S9 is used as a target for the battery can restart the engine. In addition, the processes shown in Fig. 6 are repeated as long as the ignition switch is on (step S11).

## [INDUSTRIAL APPLICABILITY]

In the apparatus 1 for estimating residual discharge capacity of a battery, the CPU 23a processing the processes in a flowchart shown in Fig. 6 works as the unit for estimating voltage drop 23a-1that estimates voltage drop of a battery terminal when the maximum current is continuously supplied at high rate discharge; and the unit for estimating residual discharge capacity 23a-2 that estimates residual discharge capacity of a battery for allowing the maximum current to be supplied continuously to the load by subtracting the undischargeable electric charge calculated from the voltage drop estimated by the unit for estimating voltage drop 23a-1 from the dischargeable charge in any state of charge.

Therefore, since the CPU 23a estimates the charge calculated by subtracting the undischargeable charge calculated based on the estimated terminal voltage drop of the battery from the dischargeable charge in any state-of-charge, as the residual discharge capacity for allowing the maximum discharge current to be continuously supplied, it is possible to properly manage the residual discharge capacity for allowing the maximum current to drive the load as long as the dischargeable charge exists.

The CPU 23a processing the processes in a flowchart shown in Fig. 6 also works as the rate-calculating device 23a-21 that calculates the rate of the estimated voltage drop to the differential voltage between the well-known full-charge open terminal voltage and the end of on-load discharge voltage, and the device for estimating capacity 23a-22 that estimates the dischargeable charge by subtracting the charge corresponding to the rate from the charge at any state of charge.

Therefore, since the CPU 23a calculates the rate of the estimated voltage drop to a differential voltage between an end of on-load discharge voltage defined by a limit voltage to supply the maximum current to the load, and an already known full-charge open circuit voltage of the battery, and estimates the residual discharge capacity by subtracting undischargeable charge calculated based on the rate from dischargeable charge in the battery in any state of charge, it is possible to easily estimate the discharge capacity of the battery in any state-of-charge by using the rate of the maximum voltage drop estimated at high rate discharge to the differential voltage previously determined as the already-known value after the maximum current is determined.

The CPU 23a processing the processes in a flowchart shown in Fig. 6 also works as the device for estimating voltage drop through resistance component 23a-11 of a battery at high rate discharge; the device for calculating voltage drop through increment of resistance component 23a-12 that is varied corresponding to the state of charge of the battery; and the device for estimating saturated voltage drop due to polarization 23a-13 as the maximum voltage drop generated by the maximum current. Further, since the CPU 23 estimates the maximum voltage drop according to the voltage estimated or calculated by the above devices, the maximum voltage drop includes the voltage drop due to the polarization increasing toward the saturation point when the maximum current continuously flows, and the voltage drop due to the resistance component including the variation resistance that is varied by the state of charge, temperature, and deterioration. Therefore, it is possible to properly manage the residual discharge capacity for reliably driving a load with all variable factors.

The CPU 23a processing the processes in a flowchart shown in Fig. 6 also works as the device for estimating the saturated voltage drop due to polarization as a voltage drop due to polarization corresponding to a maximum point of an electric current given by an approximated curve of current-polarization characteristics of the voltage drop due to polarization obtained by removing the voltage drop due to resistance component from an approximated curve of a current-voltage characteristics derived based on data pairs obtained by periodically measuring the discharge current to the load at high rate discharge, and terminal voltages of the battery corresponding to the discharge current. Further, the CPU 23a also estimates the saturated voltage drop due to polarization using the resistance component estimated at high rate discharge.

In the explanation described above, other appellations except for a battery in a vehicle are not described. However, this invention is applicable for other batteries so as to detecting the state of charge properly and to use the batteries effectively.

Incidentally, in this description, the terminal voltage affected by such as the polarization is referred to as the open voltage, and the terminal voltage in the balanced state is referred to as the open circuit voltage.

Further, this invention is naturally applicable for batteries in various vehicles such as a vehicle having a normal 14V system, or a 14V-42V multi-battery, an electric vehicle, and the like.

Incidentally, though not mentioned in the above embodiment, it is known that physical or chemical deteriorations such as lack of effective part in an electrode plate of a battery, alternation or decrease of electrolyte are generated and progresses in a battery. Therefore, residual discharge capacity including corrected variation thereof due to deterioration can be estimated by multiplying the residual discharge capacity of this invention by a predetermined degradation level. The predetermined degradation level is previously obtained such as a rate of residual discharge capacity at any state of charge to initial discharge capacity of a nondeteriorate battery or a rate of a variation of state of charge and open circuit voltage due to repetition of charge and discharge to initial state of charge and open circuit voltage.

## Claims

1. A method for estimating residual discharge capacity of a battery for allowing a maximum current to be supplied continuously to a load, said method comprising the steps of:

estimating a terminal voltage drop of the battery when a maximum current at high rate discharge is continuously supplied to the load; and estimating the residual discharge capacity by subtracting undischargeable charge calculated based on the estimated terminal voltage drop of the battery from dischargeable charge in the battery in any state of charge.

2. A method for estimating residual discharge capacity of a battery for allowing a maximum current to be supplied continuously to a load, said method comprising the steps of:

estimating a maximum terminal voltage drop of the battery when a maximum current at high rate discharge is continuously supplied to the load;
calculating a rate of the estimated maximum terminal voltage drop of the battery to a maximum allowable voltage drop of the battery corresponding to the maximum current,
estimating the residual discharge capacity by subtracting undischargeable charge calculated based on the rate from dischargeable charge in the battery in any state of charge.

3. The method for estimating residual discharge capacity of a battery as claimed in claim 2, wherein said maximum voltage drop is a differential voltage between an already known full-charge open circuit voltage of the battery and an end of on-load discharge voltage defined by a limit voltage to supply the maximum current to the load.

4. The method for estimating residual discharge capacity of a battery as claimed in any one of claims 1 to 3, wherein said estimated voltage drop includes a voltage drop due to a resistance component of the battery estimated at high rate discharge, a voltage drop due to an maximum increased resistance component varied corresponding to the state of charge of the battery estimated at high rate discharge, and a saturated voltage drop due to polarization as a maximum voltage drop due to polarization generated by the maximum current.

5. The method for estimating residual discharge capacity of a battery as claimed in claim 4, wherein said saturated voltage drop due to polarization is estimated as a maximum voltage drop due to polarization corresponding to electric current given by an approximated curve of current-polarization characteristics of the voltage drop due to polarization obtained by removing the voltage due to drop resistance component from an approximated curve of a current-voltage characteristics derived based on data pairs obtained by periodically measuring the discharge current to the load at high rate discharge, and terminal voltages of the battery corresponding to the discharge current.

6. A method for estimating residual discharge capacity of a battery for allowing a maximum current to be supplied continuously to a load, said method comprising the steps of:

estimating a maximum terminal voltage drop of the battery when a maximum current at high rate discharge is continuously supplied to the load; and
estimating the residual discharge capacity by subtracting undischargeable charge calculated based on the estimated maximum terminal voltage drop of the battery from dischargeable charge in the battery in any state of charge.

7. The method for estimating residual discharge capacity of a battery as claimed in any one of claims 1 to 6, wherein said residual discharge capacity is revised by multiplying the estimated residual discharge capacity of the battery by a previously calculated rate of residual discharge capacities of deteriorated and undetriorated batteries.

8. An apparatus for estimating residual discharge capacity of a battery for allowing a maximum current to be supplied continuously to a load, said apparatus comprising:

a device for estimating a terminal voltage drop of the battery when a maximum current at high rate discharge is continuously supplied to the load; and
a device for estimating the residual discharge capacity by subtracting undischargeable charge calculated based on the estimated terminal voltage drop of the battery from dischargeable charge in the battery in any state of charge.

9. The apparatus for estimating residual discharge capacity of a battery as claimed in claim 8 further comprising:

a device for calculating a rate of said estimated voltage drop to a differential voltage between an end of on-load discharge voltage defined by a limit voltage to supply the maximum current to the load and an already known full-charge open circuit voltage of the battery; and
a device for estimating residual discharge capacity by subtracting charge corresponding to said calculated rate using the end of on-load discharge voltage at high rate discharge from dischargeable charge in the battery in any state of charge.

10. The apparatus for estimating residual discharge capacity of a battery as claimed in claim 8,

wherein said device for estimating a terminal voltage drop includes: a device for estimating a voltage drop due to a resistance component of the battery estimated at high rate discharge; a device for calculating a voltage drop due to an maximum increased resistance component varied corresponding to the state of charge of the battery; and a device for estimating a saturated voltage drop due to polarization as a maximum voltage drop due to polarization generated by the maximum current,

wherein said device for estimating a terminal voltage drop estimates the maximum voltage drop based on voltages calculated or estimated by said respective devices.

11. The apparatus for estimating residual discharge capacity of a battery as claimed in claim 10,

wherein said device for estimating a saturated voltage drop due to polarization estimates the saturated voltage drop due to polarization as a maximum voltage drop due to polarization corresponding to electric current given by an approximated curve of current-polarization characteristics of the voltage drop due to polarization obtained by removing the voltage drop due to resistance component from an approximated curve of a current-voltage characteristics derived based on data pairs obtained by periodically measuring the discharge current to the load at high rate discharge, and terminal voltages of the battery corresponding to the discharge current.

23a—1

UNIT FOR ESTIMATING
VOLTAGE DROP

DEVICE FOR ESTIMATING
VOLTAGE DROP THROUGH
RESISTANCE COMPONENT

23a—11

DEVICE FOR CALCULATING
VOLTAGE DROP THROUGH
INCREMENT OF
RESISTANCE COMPONENT

23a—12

DEVICE FOR ESTIMATING
SATURATED VOLTAGE DROP
DUE TO POLARIZATION

23a—13

FULL-CHARGE
OPEN CIRCUIT VOLTAGE

ON-LOAD END OF
DISCHARGE VOLTAGE

RATE-CALCULATING

DEVICE

23a—21

DISCHARGEABLE CHARGE

DEVICE FOR

ESTIMATING CAPACITY

23a—22

UNIT FOR ESTIMATING RESIDUAL
DISCHARGE CAPACITY

23a—2

F I G. 1

F I G. 2

F I G.  3

F I G.  5

F I G. 4

START

SAMPLING — S 1

PROCESSING EACH SIGMA — S 2

STOP ? — S 3

N

Y

CALCULATING APPROXIMATION EQUATION — S 4

CALCULATING RESISTANCE COMPONENT — S 5

CALCULATING APPROXIMATE EQUATION OF POLARIZATION — S 6

ESTIMATING VOLTAGE DROP DUE TO THE RESISTANCE COMPONENT — S 7

CALCULATING A D C RATE — S 8

ESTIMATING A D C — S 9

OTHER PROCESSING — S 10

I G SW OFF ? — S 11

N

Y

STOP

F I G. 6

## INTERNATIONAL SEARCH REPORT

| International application No. |
| --- |
| PCT/JP2004/003914 |

**A. CLASSIFICATION OF SUBJECT MATTER**
Int.Cl⁷ G01R31/36

According to International Patent Classification (IPC) or to both national classification and IPC

**B. FIELDS SEARCHED**

Minimum documentation searched (classification system followed by classification symbols)
Int.Cl⁷ G01R31/36

Documentation searched other than minimum documentation to the extent that such documents are included in the fields searched
| | | | |
| --- | --- | --- | --- |
| Jitsuyo Shinan Koho | 1922–1996 | Jitsuyo Shinan Toroku Koho | 1996–2004 |
| Kokai Jitsuyo Shinan Koho | 1971–2004 | Toroku Jitsuyo Shinan Koho | 1994–2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y<br>A | JP 7-84015 A (Toyota Motor Corp.),<br>31 March, 1995 (31.03.95),<br>Full text; all drawings<br>(Family: none) | 1,7,8,<br>2-6,9-11 |
| Y<br>A | JP 2002-174133 A (Japan Storage Battery Co.,<br>Ltd.),<br>21 June, 2002 (21.06.02),<br>Full text; all drawings<br>(Family: none) | 1,7,8<br>2-6,9-11 |
| Y | JP 2001-51030 A (Hitachi Maxell, Ltd.),<br>23 February, 2001 (23.02.01),<br>Full text; all drawings<br>& US 6294894 B1 | 7 |

☐ Further documents are listed in the continuation of Box C.    ☐ See patent family annex.

| | |
| --- | --- |
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>11 June, 2004 (11.06.04) | Date of mailing of the international search report<br>06 July, 2004 (06.07.04) |
| --- | --- |
| Name and mailing address of the ISA/<br>    Japanese Patent Office | Authorized officer |
| Facsimile No. | Telephone No. |

Form PCT/ISA/210 (second sheet) (January 2004)